Europäisches Patentamt

European Patent Office

Office européen des brevets

(11) Veröffentlichungsnummer: **0 297 236**
**A2**

(12) **EUROPÄISCHE PATENTANMELDUNG**

(21) Anmeldenummer: **88106470.3**

(22) Anmeldetag: **22.04.88**

(51) Int. Cl.⁴: **H05K 3/32**

(30) Priorität: **25.06.87 DE 3720925**

(43) Veröffentlichungstag der Anmeldung:
**04.01.89 Patentblatt 89/01**

(84) Benannte Vertragsstaaten:
**DE FR GB IT**

(71) Anmelder: **WABCO Westinghouse Fahrzeugbremsen GmbH**
**Am Lindener Hafen 21 Postfach 91 12 80**
**D-3000 Hannover 91(DE)**

(72) Erfinder: **Cnyrim, Henner; Dipl.-Ing.**
**Lange Weihe 25 h**
**D-3014 Laatzen(DE)**
Erfinder: **Felsen, Peter**
**Lübecker Strasse 38**
**D-3015 Wenningsen OT Argestorf(DE)**

(74) Vertreter: **Schrödter, Manfred**
**WABCO Westinghouse Fahrzeugbremsen GmbH Am Lindener Hafen 21 Postfach 91 12 80**
**D-3000 Hannover 91(DE)**

(54) **Leiterplatte.**

㊗ Bei Leiterplatten, die für gemischte Bestückung mit bedrahteten und oberflächenmontierbaren Bauelementen vorgesehen sind, entstehen mitunter Schwierigkeiten bei der Verklebung großer Bauelemente und thermische Probleme bei der Überkopflötung im Schwallötbad.

Um Leiterplatten für gemischte Bestückung auch mit PLCC-Bauelementen (7) versehen zu können, die zum Teil sonst nicht einsetzbar sind, wurde eine Leiterplatte (1) geschaffen, die mit einer Aussparung (19) für derartige Bauelemente versehen ist. Dabei ist die Aussparung (19) an ihren Seiten (5) mit Einbuchtungen (21) versehen, die zur Führung und zur Kontaktierung der einsetzbaren Bauelemente dienen.

Fig. 1

## Leiterplatte

Die Erfindung betrifft eine Leiterplatte gemäß dem Oberbegriff des Patentanspruchs 1.

Derartige Leiterplatten mit Leiterbahnen werden für elektronische Schaltungen benötigt, bei denen in der Regel unterschiedliche elektronische Bauelemente auf bestimmte Weise miteinander zu verbinden sind. Es ist bekannt, die mit Leiterbahnen versehenen Leiterplatten an den Anschlußpunkten der Bauelemente zu durchbohren und die Drahtanschlüsse der vorgesehenen Bauelemente in die Bohrungen zu stecken und mit den Leiterbahnen zu verlöteten. Es ist ferner bekannt, sogenannte oberflächenmontierbare Bauelemente (SMD = Surface Mounted Devices) zu verwenden, die unmittelbar auf die Leiterplatte geklebt werden, wobei deren Anschlußpunkte auf den vorgesehenen Leiterbahnen aufliegen und die mit diesen zu verlöten sind. Durch diese Technik wird durch die kleineren Bauelemente und die flache Bauelementeanordnung Einbauraum eingespart. Darüber hinaus kann durch den Wegfall des Bohrvorgangs der Produktionsaufwand gesenkt werden.

Da verschiedentlich für bestimmte Zwecke manche Bauelemente nur noch in SMD-Technik angeboten werden oder diese schon aus Kostengründen eingesetzt werden sollen, so ist es häufig erforderlich, beide Bauelementearten (gemischte Bestückung) gemeinsam auf einer Leiterplatte anzuordnen.

Derartige Leiterplatten für Baugruppen mit gemischter Bauelementebestückung sind aus dem Prospekt "Siemens-Teststrategie und Prüfverfahren für SMD-Baugruppen", Ausgabe 53 d 7/86 der Siemens AG bekannt. Dort werden Leiterplatten beschrieben, bei denen die eine Seite (Oberseite) mit bedrahteten Bauelementen bestückt ist, während auf der gegenüberliegenden Seite (Unterseite) die SMD-Bauelemente angeordnet sind. Hierbei werden die Leiterplatten auf herkömmliche Weise mit Leiterbahnen versehen, die an den Verbindungspunkten für die bedrahteten Bauelemente Bohrungen enthalten, in die die Drahtanschlüsse eingeführt werden. Hingegen sind die SMD-Bauelemente auf der Unterseite der Leiterplatte aufklebbar. Dabei liegen die Kontaktflächen der Bauelemente auf den vorgesehenen Leiterbahnen auf. Die ganze Baugruppe ist dann in einem Arbeitsgang im Schwallbad lötbar. Hierbei werden die SMD-Bauelemente mit ihren gesamten Gehäuseteil überkopf durch die Lötwelle geführt. Dabei werden die Bauelemente unter Umständen auf allen Seiten von geschmolzenem heißen Lot kurzzeitig berührt. Da allerdings nicht alle SMD-Bauelemente für eine derart hohe thermische Belastung ausgelegt sind, ist eine solche Bauelementeanordnung auf einer Leiterplatte nicht immer möglich.

Der Erfindung liegt deshalb die Aufgabe zugrunde, eine Leiterplatte so auszubilden, daß die oberflächenmontierbaren Bauelemente beim Löten im wesentlichen einer geringen thermischen Belastung ausgesetzt werden.

Diese Aufgabe wird durch die im Patentanspruch 1 angegebene Erfindung gelöst. Weiterbildungen und vorteilhafte Ausführungsbeispiele der Erfindung sind in den Unteransprüchen angegeben.

Es ist zwar auch denkbar bei Leiterplatten für gemischte Bestückung, die SMD-Bauelemente durch die Anwendung eines Reflow-Lötverfahrens nur einer geringen thermischen Belastung auszusetzen. Dann müßten die SMD-Bauelemente zunächst auf einer Leiterplattenseite aufgebracht und im Reflow-Verfahren gelötet werden. In einem weiteren Arbeitsgang wäre dann die Leiterplatte auf der selben Seite mit den bedrahteten Bauelementen zu bestücken und auf der anderen Seite im Schwallbad zu löten. Dabei würden allerdings die Lötstellen der SMD-Bauelemente nochmals kurzzeitig erhitzt, was dann leicht zu Fehlern im Lötstellenbereich führen kann. Hierdurch würde nicht nur die Rate der Fertigungsfehler steigen, sondern hierdurch könnten auch leicht Lötstellenfehler entstehen, die erst nach längerer Betriebszeit zu Funktionsstörungen führen. Derartige Lötstellen stellen aber vor allem bei sicherheitstechnischen Anlagen, wie z.B. ABS-Bremsanlagen, ein zu großes Gefahrenpotential dar und sind deshalb nicht geeignet die erforderliche Betriebssicherheit zu gewährleisten.

Die Erfindung hat deshalb den Vorteil, daß die hitzeempfindlichen oberflächenmontierbaren Bauelemente in eine Aussparung der Leiterplatte einsetzbar sind. Dadurch kann das Bauelement so in der Aussparung positioniert werden, daß beim Löten im Schwallbad die Lötwelle nur mit den Kontaktstiften oder nur mit der Unterseite der oberflächenmontierbaren Bauelemente in Berührung kommt. Dadurch tritt eine wesentlich geringere thermische Belastung auf, als wenn das gesamte Bauelement durch die Lötwelle geführt wird.

Darüber hinaus bietet die Erfindung auch den Vorteil, daß bei einer Anordnung der SMD-Bauelemente in der Aussparung die Packungsdichte erhöht wird. Denn die SMD-Bauelemente füllen im wesentlichen nur den Raum in der Aussparung aus und deshalb können die Leiterplatten dichter zusammen angeordnet werden.

Gleichzeitig hat die Erfindung auch den Vorteil der besseren Prüfbarkeit, der in der Aussparung angeordneten SMD-Bauelemente. Durch die Aussparung in der Leiterplatte und durch die Anordnung der Kontaktierungselemente an der Seitenwand der Leiterplatte ist der zu überprüfende Anschlußpunkt des SMD-Bauelementes von jeder Leiterplattenseite aus erreichbar. Deshalb kann sowohl eine Sichtprüfung, als auch eine Bauteilemessung von jeder Leiterplattenseite aus vorgenommen werden.

Weiterhin ist vorteilhaft, daß durch die Erfindung auch eine geringere Fehlerhäufigkeit erreichbar ist. Durch die Anordnung der SMD-Bauelemente in der Aussparung brauchen die ganzen Bauelemente nicht mehr durch die Lötwelle geführt zu werden, sondern nur noch dessen Anschluß. Dadurch sind Lötmittelfäden zwischen den Bauteilen bzw. zwischen den Bauteilanschlüssen weitgehend vermeidbar, weil die mit Lot benetzbaren Kontaktierungsoberflächen erheblich geringer sind.

Bei einer Leiterplatte für gemischte Bestückung ist durch die Erfindung insbesondere von Vorteil, daß die Leiterplatte nur von einer Seite aus mit Bauelementen bestückt zu werden braucht. Denn durch die Aussparung können die SMD-Bauelemente von der selben Leiterplattenseite aus auf ihren vorgesehenen Platz positioniert werden, wie die bedrahteten Bauelemente.

Bei einer vorteilhaften Ausführungsform der Erfindung sind die SMD-Bauelemente so in die Aussparung einpaßbar, daß ihre Anschlußdrähte federnd an den Kontaktierungselementen der Aussparungswände anliegen und sich durch die Federkraft der Anschlußdrähte in der Aussparung halten. Dies ist insbesondere bei den SMD-Bauelementen von Vorteil, die wegen der formgebung ihres Gehäuseteils nicht über eine klebbare Auflagefläche verfügen und deshalb auch nicht überkopf durch die Lötwelle geführt werden können.

Die Erfindung wird anhand eines Ausführungsbeispiels, das in der Zeichnung dargestellt ist, näher erläutert.

Es zeigen:

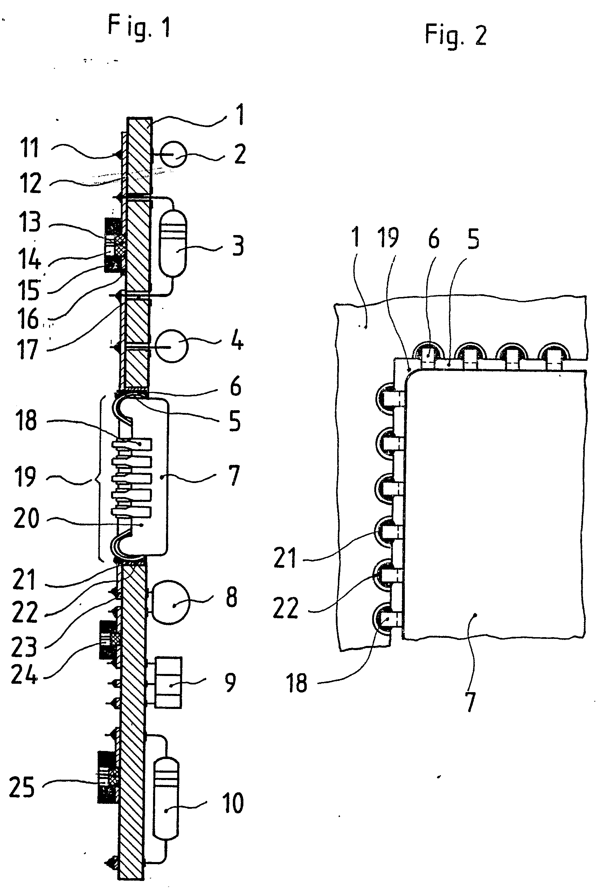

Fig. 1 einen Längsschnitt durch eine gemischt bestückte Leiterplatte mit einem SMD-Bauelement in einer Aussparung und

Fig. 2 einen Ausschnitt der Draufsicht der Leiterplatte nach Fig. 1 mit der Aussparung und dem SMD-Bauelement.

Die Zeichnung zeigt eine gemischt bestückte Leiterplatte mit Aussparung, in der ein SMD-Bauelement in PLCC-Gehäuseform (PLCC = Plastic Leaded Chip Carriers) angeordnet ist.

Die Leiterplatte (1) besteht aus einem herkömmlichen Kunststoffmaterial, auf der auf der einen Seite (Unterseite) verzinnte Leiterbahnen (12, 23) aufgebracht sind. Auf der den Leiterbahnen (12, 23) gegenüberliegender Seite (Oberseite) der Leiterplatte (1) sind bedrahtete Widerstände (2, 3, 4, 10), ein bedrahteter Kondensator (8) und ein bedrahteter Transistor (9) angeordnet. Dabei wurden die Drahtanschlüsse durch Bohrungslöcher (17) geführt und mit den Leiterbahnen (12, 23) auf herkömmliche Weise verlötet.

· Auf der Unterseite der Leiterplatte (1), auf der sich die Lötstellen (11) der bedrahteten Bauelemente befinden, sind zusätzlich noch SMD-Bauelemente (14, 24, 25) aufgebracht. Die einzelnen Bauelemente sind durch eine Klebestelle (13) auf der Leiterplatte (1) positioniert. Dabei liegen die Bauelemente mit ihren Kontaktierungsflächen (15) auf den entsprechenden Leiterbahnen (12) auf und werden mit diesen durch eine Lötstelle verbunden. Die Leiterbahnen (12) sind an diesen Stellen als Kontaktflächen (16) ausgebildet. Durch eine derartige gemischte Bestückung auf Leiterplatten ist eine große Packungsdichte von Bauelementen erreichbar.

Eine solche Anordnung von SMD-Bauelementen ist grundsätzlich auf allen Leiterplattenausführungen möglich. Diese Leiterplatten müssen lediglich über die entsprechenden Kontaktflächen (16) auf den Leiterbahnen (12) verfügen, während die SMD-Bauelemente entsprechende Klebefläche aufweisen und thermisch belastbar sein müssen. Die thermischen Anforderungen sind deshalb erforderlich, weil die Leiterplatten (1) in der Regel überkopf im Schwallbad gelötet werden und dabei die gesamte Oberfläche der SMD-Bauelemente mit heißem Lot in Berührung kommt.

Etwa in der Mitte der Leiterplatte (1) befindet sich eine quadratische Aussparung (19), in der der Einsatz eines SMD-Bauteils (7) im PLCC-Gehäuse vorgesehen ist. Dieses hat an seinem Umfang eine Reihe von Anschlüssen, die als Anschlußdrähte (6, 18) ausgebildet sind. Die Aussparung (19) besitzt etwa eine Größe, die der Fläche des PLCC-Kunststoffgehäuses (20) entspricht, und hat an ihren vier Seitenwänden (5) halbkreisförmige Einbuchtungen (21), in die die Anschlußdrähte (6, 18) zur Anlage kommen. Diese Einbuchtungen (21) sind innen verzinnt und dienen als Kontaktierungselemente (22) für die Anschlußdrähte (6, 18). Dabei sind die verzinnten Einbuchtungen (21) zur elektrischen Verbindung mit den entsprechenden Leiterbahnen (23) verbunden. Die Kontaktierungselemente (22) können aber auch anders ausgebildet sein. Die spezielle Ausgestaltung richtet sich in erster Linie nach der Art der Anschlüsse der jeweils einzusetzenden Bauelemente.

Die Anschlußdrähte (18, 6) liegen federnd an den Wänden der Einbuchtungen (21) an und bilden dadurch gleichzeitig einen mechanischen Halt des Bauelementes (7), das dadurch während des Lötvorgangs keiner besonderen Halterung mehr bedarf.

Durch die Einbuchtungen (21) werden die jeweiligen Anschlußdrähte (6, 18) bei der Bestückung der Leiterplatte (1) selbsttätig in die vorgesehene Position geleitet, so daß eine Führung des Bauelementes (7) gewährleistet ist. Diese Führungseigenschaft der Einbuchtungen (21) gestattet auch eine automatische Bestückung der Leiterplatte (1) mit derartigen SMD-Bauteilen, die auch gleichzeitig mit der Bestückung der bedrahteten Bauelemente erfolgen kann. Die Anforderungen an eine genaue Positionierung der Bauelemente bei einer automatischen Bestückung sind deshalb vergleichsweise gering.

Die Aussparung (19) muß dabei auch nicht quadratisch sein, sondern kann auch jede andere Form annehmen, die dann lediglich von der Form des einzusetzenden Bauelementes abhängt. Grundsätzlich können alle SMD-Bauelemente in eine derartige Aussparung eingesetzt werden. Es empfiehlt sich aber nur für diejenigen Bauteile, die wegen ihrer Größe und Form nicht auf der Leiterplatte aufklebbar sind oder die wegen ihrer Temperaturempfindlichkeit nicht überkopf gelötet werden können. Darüber hinaus gestattet die Anordnung derartiger Bauteile in Aussparungen (19), daß die Leiterplatte (1) in einem einzigen Lötvorgang gelötet werden kann. Dabei entstehen durch die Einbuchtungen (21), in denen die Anschlußdrähte(6, 18) anliegen, eine Kapillarwirkung, durch die eine zuverlässige Lötverbindung begünstigt wird. Im übrigen gestattet die Aussparung (19) auch eine übersichtliche Kontrollmöglichkeit der eingesetzten Bauteile.

Eine Leiterplatte mit derartiger Aussparung (19) bietet sich insbesondere für den Einsatz von Bauteilen mit PLCC-Gehäusen an, da diese Bauelemente wegen ihrer Größe und Form häufig nicht auf die Leiterplatte zu kleben sind. Diese Bauelemente können meist auch nicht durch andere Bauformen ersetzt werden, da mitunter nur eine Ausführungsart in PLCC-Gehäusen angeboten wird.

Eine Leiterplatte für gemischte Bestückung mit Aussparungen wird wie folgt hergestellt:

Es ist zunächst eine handelsübliche Leiterplatte (1) zu verwenden, auf der die erforderlichen Leiterbahnen (12, 23) bereits vorhanden sind. Daraufhin werden die Löcher für die Anschlußdrähte der bedrahteten Bauelemente (2, 3, 4, 8, 9, 10) in die Leiterplatte (1) gebohrt.

Bei der vorgesehenen Aussparung (19) werden die Bohrlöcher entlang der Aussparungsseitenwände (5) angebracht. Dabei werden die Mittelpunkte der Bohrungen auf der Linie der Aussparungsseiten vorgesehen. Für jeden vorgesehenen Anschlußdraht (6, 16) wird ein Bohrloch an die entsprechende Stelle in die Leiterplatte (1) gebohrt.

Jedes Bohrloch befindet sich dann mit der einen Hälfte in der vorgesehenen Aussparung (19) und mit der anderen Hälfte in der verbleibenden Leiterplatte (1).

Anschließend werden die Leiterbahnen (12) und die Bohrlöcher im hergebrachten Verfahren mit Zinn benetzt. Nachfolgend wird die Aussparung für das SMD-Bauelement (7) im PLCC-Gehäuse ausgearbeitet. Dabei wird die Aussparung (19) in der Regel ausgestanzt oder ausgefräst. Es sind aber auch andere Verfahren denkbar, um die Aussparung auszuarbeiten.

Nach dem Ausstanzen enthält die Leiterplatte (1) eine quadratische Aussparung (19), an dessen Seitenwänden (5) halbrunde Einbuchtungen (21) verblieben sind. Diese verzinnten Einbuchtungen (21) stellen gleichzeitig eine elektrische Verbindung zu den entsprechenden Leiterbahnen (23) her.

Die Leiterplatte ist nachfolgend mit den entsprechenden Bauelementen bestückbar und kann in einem Arbeitsgang im Schwallbad gelötet werden.

## Ansprüche

1. Leiterplatte aus isoliertem Trägermaterial auf dem wenigstens eine Leiterbahn aufgebracht ist, dadurch gekennzeichnet, daß mindestens eine Aussparung (19) zum Einsatz von oberflächenmontierbaren Bauelementen (7) vorgesehen ist, deren Abmessungen etwa denen der Grundfläche des einzusetzenden oberflächenmontierbaren Bauelementes (7) entsprechen und daß mindestens eine Seitenwand (5) der Aussparung (19) mit mindestens einem Kontaktierungselement (22) versehen ist, das zur elektrischen Verbindung der Leiterbahn (23) mit einem elektrischen Anschluß des oberflächenmontierbaren Bauelementes (7) dient.

2. Leiterplatte nach Anspruch 1, dadurch gekennzeichnet, daß das Kontaktierungselement (22) von einem Kontaktmaterial gebildet wird, welches auf der Oberfläche einer Einbuchtung (21) an der Seitenwand (5) aufgebracht ist.

3. Leiterplatte nach Anspruch 1 oder 2, dadurch gekennzeichnet, daß das Kontaktierungselement (22) so angeordnet ist, daß es dem elektrischen Anschluß (6) des einzusetzenden oberflächenmontierbaren Bauelementes (7) gegenüberliegt und daß der Anschluß (6) des oberflächenmontierbaren Bauelementes (7) an dem Kontaktierungselement (22) anlegbar ist.

4. Leiterplatte nach mindestens einem der vorhergehenden Ansprüche, dadurch gekennzeichnet, daß die Längsachse der Einbuchtung (21) senkrecht oder in etwa senkrecht zur Oberfläche der Leiterplatte (1) verläuft und daß die Einbuchtung (21) senkrecht zu der Längsachse einen halbkreisförmigen oder in etwa halbkreisförmigen Querschnitt aufweist.

5. Verfahren zum Herstellen einer Leiterplatte nach Anspruch 1, dadurch gekennzeichnet, daß im Bereich mindestens einer Seitenwand (5) einer noch herauszuarbeitenden Aussparung (19) mindestens ein Loch herausgearbeitet wird, dessen Innenwandung danach so durchkontaktiert wird, daß sie wenigstens teilweise mit Kontaktmaterial bedeckt ist und mit einer zugeordneten Leiterbahn (23) elektrisch in Verbindung steht.

6. Verfahren nach Anspruch 5, dadurch gekennzeichnet, daß die Aussparung (19) so herausgearbeitet wird, daß das Loch etwa zur Hälfte als Einbuchtung in der Seitenwand der Aussparung (19) verbleibt.

7. Verfahren nach Anspruch 5 oder 6, dadurch gekennzeichnet, daß die Aussparung (17) durch einen Stanzvorgang herausgearbeitet wird.

Fig. 1

Fig. 2